# EUROPÄISCHE PATENTSCHRIFT

(11) **EP 1 842 404 B1**
(45) Veröffentlichungstag und Bekanntmachung des Hinweises auf die Patenterteilung: **03.09.2014**
(21) Anmeldenummer: 06704381.0
(22) Anmeldetag: 24.01.2006
(51) Int. Cl.: H05K 1/11

(54) **VERFAHREN ZUR HERSTELLUNG EINER ABWINKELBAREN LEITERPLATTENSTRUKTUR AUS ZUMINDEST ZWEI LEITERPLATTENABSCHNITTEN**
METHOD FOR PRODUCING AN ANGLED PRINTED CIRCUIT BOARD STRUCTURE FROM AT LEAST TWO CIRCUIT BOARD SECTIONS
PROCEDE DE FABRICATION D'UNE STRUCTURE DE CARTE DE CIRCUITS IMPRIMES PLIABLE CONSTITUEE D'AU MOINS DEUX SECTIONS DE CARTE DE CIRCUITS IMPRIMES

(30) Priorität: 24.01.2005 DE 102005003369
(43) Veröffentlichungstag der Anmeldung: 10.10.2007
(73) Patentinhaber: JUMATECH GmbH, 90542 Eckental (DE)
(72) Erfinder: WÖLFEL, Markus, D-90542 Eckental (DE)
(74) Vertreter: Grünecker, Kinkeldey, Stockmair & Schwanhäusser
(86) Internationale Anmeldenummer: PCT/EP2006/000613
(87) Internationale Veröffentlichungsnummer: WO 2006/077164

(56) Entgegenhaltungen:
- WO-A-02/067642
- WO-A-2004/012488
- US-A- 4 533 787
- US-A- 5 442 519
- US-A1- 2005 012 194

## Beschreibung

Die Erfindung betrifft ein Verfahren zur Herstellung einer abwinkelbaren Leiterplattenstruktur aus zumindest zwei Leiterplattenabschnitten sowie eine abwinkelbare Leiterplattenstruktur aus wenigstens zwei zueinander winkelig anordenbaren Leiterplattenabschnitten. Die US 5 442 519 offenbart eine Leiterplatte mit zwei Leiterplattenabschnitten, die entlang einer Nut auseinander gebrochen werden können.

Üblicherweise werden Signale und Ströme auf Leiterplatten in Leiterbahnen fortgeleitet, welche durch ein Ätzverfahren hergestellt sind, d.h. von einem auf einer Trägerplatte aufgebrachten leitfähigen, dünnen Flächenelement (z.B. Kupferfolie) werden zwischen den gewünschten Leiterbahnen liegende Bereiche abgeätzt, wodurch sich diskrete, voneinander isolierte Anschluss- und Leiterbahnstrukturen auf der Oberfläche der Trägerplatte erzeugen lassen. Bei drahtbeschriebenen Leiterplatten werden hingegen Leitungsdrähte aus elektrisch leitfähigem Material zwischen als Anschlussstellen vorgesehenen Bereichen des leitfähigen, dünnen Flächenelements verlegt und beispielsweise zusammen mit diesem in Verbundbauweise in einem Block aus Isolierstoffmasse zur Ausbildung einer Leiterplatte eingegossen.

Ein Verfahren zur Herstellung einer solchen drahtbeschriebenen Leiterplatte ist beispielsweise aus der DE 101 08 168 C1 bekannt. Diese Druckschrift beschreibt ein Verfahren zur Herstellung einer Multiwire-Leiterplatte unter Anwendung eines Drahtschreibeverfahrens, wobei auf der Innenseite eines dünnen Flächenelements aus elektrisch leitfähigem Material der Drahtverschreibung entsprechende Leitungsdrähte definiert verlegt und an definierten Kontaktstelle des Flächenelements kontaktiert und festgelegt werden. Anschließend wird auf der Innenseite des Flächenelements mit den kontaktierten Leitungsdrähten ein Stabilisierungsflächenelement festgelegt. Danach wird das dünne Flächenelement von seiner Außenseite her derartig strukturiert, dass die Kontaktstellen vom übrigen Flächenelement getrennt und somit elektrisch voneinander isoliert werden. Derartige Leiterplatten geringer Dicke können zu einer kompakten Mehrlagenschaltung zusammengebaut werden. Zu unterscheiden sind folglich drahtgeschriebene Platinen, in welchen Leitungsdrähte eingebettet und zwischen beispielsweise den Anschlussstellen elektronischer Bauelemente verlegt sind, von Leitungsverbindungen konventioneller Leiterplatten, bei welchen die Leitungsverbindungen von einer Leiterplattenoberseite nachträglich mit den Anschlussstellen verbunden werden können, um Ströme oder Signale beispielsweise zwischen getrennten Leiterplatten zu übertragen.

Aus Gründen eines beengten Bauraums ist es manchmal notwendig, Leiterplatten, weiche miteinander in elektrischer Verbindung stehen sollen, in einer räumlichen Struktur anzuordnen. Dies bedeutet, dass die einzelnen Leiterplatten der Struktur zueinander winkelig angeordnet werden, wobei zwischen den einzelnen Leiterplatten elektrische Verbindungen, beispielsweise in Form von elektrisch leitfähigen Leitungsdrähten, hergestellt werden müssen. Beim Stand der Technik wird dies beispielsweise dadurch realisiert, dass die einzelnen Leiterplatten der Struktur getrennt voneinander gefertigt und auf jeder Leiterplatte durch das Ätzverfahren eine eigene Leiterbahn- und Anschlussstruktur mit entsprechenden Anschlussstellen für die Leitungsdrähte zur Verbindung der getrennten Leiterplatten hergestellt werden. Danach werden die Leitungsdrähte an den entsprechenden Anschlussstellen für die Leitungsdrähte zur Verbindung der getrennten Leiterplatten bei den verschiedenen Leiterplatten beispielsweise durch Löten oder Schweißen befestigt und so die getrennten Leiterplatten elektrisch miteinander verbunden.

Der vorliegenden Erfindung liegt demzufolge die Aufgabe zugrunde, ein Verfahren der eingangs erwähnten Art derart weiterzuentwickeln, dass es kostengünstiger und einfacher zu realisieren ist. Diese Aufgabe wird erfindungsgemäß gelöst durch ein Verfahren zur Herstellung einer abwinkelbaren Leiterplattenstruktur aus zumindest zwei Leiterplattenabschnitten nach Anspruch 1.

In Bezug auf den Vorrichtungsaspekt der vorliegenden Erfindung wird die Aufgabe durch eine abwinkelbare Leiterplattenstruktur aus wenigstens zwei zueinander winkelig anordenbaren Leiterplattenabschnitten gemäß Anspruch 18 gelöst. Diese Leiterplattensmodular umfasst wenigstens einen zumindest überwiegend in der Leiterplattenstruktur eingebetteten Leitungsdraht, der sich zwischen zwei als Anschlussstellen vorgesehenen Bereichen der Leiterplattenstruktur erstreckt und mit diesen elektrisch leitend verbunden ist, wobei sich die beiden als Anschlussstellen vorgesehenen Bereiche auf verschiedenen Leiterplattenabschnitten befinden, wobei die Leiterplattenabschnitte unter Beibehaltung der Verbindung der als Anschlussstellen vorgesehenen Bereiche durch den wenigstens einen Leitungsdraht und unter Biegung des wenigstens einen Leitungsdrahts gegeneinander abwinkelbar sind.

Dabei kann eine zunächst ebene Leiterplatte beispielsweise entsprechend des vorbeschriebenen Verfahrens aus der DE 101 08 168 C1 hergestellt werden, wobei auf der Innenseite eines dünnen Flächenelements aus elektrisch leitendem Material der Drahtverschreibung entsprechende Leitungsdrähte definiert verlegt und an den definierten Kontaktstellen des Flächenelements kontaktiert und festgelegt werden. Anschließend wird auf der Innenseite des Flächenelements mit den kontaktierten Leitungsdrähten ein Stabilisierungsflächenelement beispielsweise in Form eines Prepregs oder einer in Isolierharz eingegossenen Armierungsschicht verbunden. Danach wird das dünne Flächenelement von seiner Außenseite her, beispielsweise durch mechanische Bearbeitung, Laserabdampfung oder Ätzung derartig strukturiert, dass die Kontaktstellen vom übrigen Flächenelement getrennt und somit diskretisiert und elektrisch voneinander isoliert werden. Eine derartige ebene Leiterplatte kann dann beispielsweise mit wenigsten einer Abwinkelkante z.B. durch Abtrag von Leiterplattenmaterial mittels Laserabtrag ' oder mechanischer Entfernung durch Fräsen versehen werden. Anschließend kann beispielsweise eine Bestückung mit elektronischen oder elektrischen Bauelementen im zunächst noch flachen Zustand der abwinkelbaren Leiterplattenstruktur vorgenommen werden. Alternativ können die elektrischen oder elektronischen Bauelemente an zumindest einigen der Anschlussstellen auch nach dem Abwinkeln der Leiterplattenabschnitte angeschlossen werden.

Die mit diesem Verfahren erzielbaren Vorteile sind darin zu sehen, dass die elektronische Schaltung und alle elektrischen Verbindungen der räumlichen Leiterplattenstruktur in einem Arbeitsgang an einer einzigen, zunächst noch ebenen Leiterplatte hergestellt werden können. Darüber hinaus können weitere Arbeitsgänge wie die Bestückungsvorgänge mit elektronischen Bauelementen, das Abgleichen, die Schaltungsprüfung, die Fehlersuche und eventuelle Reparaturen ebenfalls im ebenen Zustand der Leiterplatte durchgeführt werden. Insbesondere ist eine Fehlersuche und Reparatur in diesem ebenen Zustand besonders einfach möglich, weil noch keine räumliche Struktur ausgebildet ist, welche die Zugänglichkeit zu einzelnen Bauelementen der Schaltung behindern könnte. Die winkelige Anordnung der einzelnen Leiterplattenabschnitte zueinander kann durch einfaches Biegen der flexiblen Leitungsdrähte hergestellt werden, welche die Leiterplattenabschnitte miteinander verbinden.

Ein weiterer vorteilhafter Aspekt einer solchen abgewinkelten Anordnung ist die gute thermische, elektrische oder elektromagnetische Trennung oder Entkopplung verschiedener Schaltungsbereiche. Außerdem kann ein solcher abgewinkelter Bereich einer Leiterplattenstruktur vorteilhaft zur Anbringung von Anzeige- bzw. Eingabebauelementen und Buchsen beispielsweise an der Frontseite und unter Umständen in verschiedenen Befestigungsebenen dienen.

Weiterhin ist es möglich, durch das erfindungsgemäße Verfahren ein geschlossenes Leiterplattengehäuse durch Verbinden einer aus sechs Teilflächen bestehenden Abwicklung eines Quaders aus einer abwinkelbaren, ebenen Leiterplattenstruktur zu fertigen und so ein geschlossenes Leiterplattengehäuse, das innen- wie außenseitig bestückbar ist, herzustellen.

Auf diese Weise ist es vorteilhaft möglich, Bauteile beispielsweise vor kondensierender Feuchtigkeit, Chemikalien oder anderen schädlichen Einflüssen oder starken Temperaturschwankungen im Inneren des Gehäuses geschützt unterzubringen. Hierbei ist es auch möglich, die im Inneren des Leiterplattengehäuses montierten Bauelemente der Schaltung vor wechselnden Umwelteinflüssen zu schützen und ggf. auch zu temperieren und vor Zugluft zu schützen und so Beeinträchtigungen der Funktion und Genauigkeit oder vorzeitige Alterung zu verhindern. Ein weiterer sehr wichtiger Aspekt liegt in der elektrostatischen und elektromagnetischen Schirmung, im sogenannten "EGB-Schutz" von elektrostatisch sensitiven Bauteilen sowie im Hochspannungsschutz von Menschen und elektronischen Komponenten.

Weiterhin kann auf diese Weise auch der unerwünschte Einblick, Zugriff oder Reparaturversuch durch unbefugte Personen wirksam unterbunden werden. Außerdem ist es möglich, mittels des erfindungsgemäßen Verfahrens sehr kompakte, robuste und mechanisch hochbelastbare Leiterplattenstrukturen zu schaffen, die durch eine sehr hohe Zuverlässigkeit der Leitungsverbindungen zwischen den einzelnen Leiterplattenabschnitten und eine sehr geringe Fehlerrate bei der Herstellung und minimale Ausfallrate im Einsatz auszeichnen. Insbesondere durch die Führung der Leitungsdrähte innerhalb der Leiterplattenstrukturen und in geschützten Bereichen der Abwinkelnut ist eine nachträgliche Beschädigung dieser Leitungsdrahtverbindungen nach dem Herstellungsprozess nahezu ausgeschlossen.

In einer bevorzugten Ausführungsform kann die Leiterplatte mit elektrischen Anschlussstellen versehen werden, wodurch einzelne Bereiche der Platine, die mittels Drahtverschreibung mit einem Leitungsdraht verbunden sein können und/oder zur Bestückung mit Bauteilen vorgesehen sein können und/oder der Fortleitung von Signalen oder Strömen dienen können und/oder dem Anschluss externer Komponenten dienen können, voneinander isoliert ausgebildet werden können.

In einer weiteren bevorzugten Ausführungsform kann der Leitungsdraht mittels Drahtschreibung aufgebracht und mit den als Anschlussstellen vorgesehenen Bereichen der Leiterplatte vorzugsweise verschweißt werden. Durch dieses Verfahren ist ein besonders zuverlässiges, wirtschaftliches und effizientes Verbinden von Anschlussbereichen mittels drahtverschriebenem Leitungsdraht möglich.

In einer weiteren bevorzugten Ausführungsform kann entlang der Abwinkelkante die Steifigkeit und/oder Festigkeit der Leiterplatte gegenüber angrenzenden Bereichen herabgesetzt sein. Durch eine solche Veränderung von mechanischen Parametern kann die Leiterplattenstruktur entlang den dafür vorgesehenen Faltungslinien ohne Beschädigung der im Inneren der Leiterplattentstruktur verlaufenden Leitungsdrähte abgewinkelt werden.

In einer weiteren bevorzugten Ausführungsform kann entlang der Abwinkelkante die Stärke der Leiterplatte gegenüber angrenzenden Bereichen verringert sein. Dies stellt eine besonders einfache Möglichkeit dar, um Leiterplattenabschnitte der Leiterplattenstruktur gelenkig miteinander zu verbinden.

In einer weiteren bevorzugten Ausführungsform kann die Abwinkelkante durch teilweises Entfernen von Leiterplattenmaterial hergestellt sein. Dies stellt insbesondere im Klein-und Mitteiserienbereich eine sinnvolle, kostengünstige und herstellungstechnisch flexible Möglichkeit dar, um die Leiterplattenabschnitte gegeneinander beweglich zu gestalten.

In einer weiteren bevorzugten Ausführungsform kann nach dem teilweisen Entfernen von Leiterplattenmaterial wenigstens ein Leiterplattenabschnitt gegenüber wenigstens einem anderen Leiterplattenabschnitt unter Beibehaltung der Verbindung der als Anschlussstellen vorgesehenen Bereiche durch den wenigstens einen Leitungsdraht und unter Biegung des wenigstens einen Leitungsdrahtes abgewinkelt werden. Durch das partielle Entfernen von Leiterplattenmaterial wird dabei die Steifigkeit der Leiterplattenstruktur im Knickbereich soweit herabgesetzt und die neutrale Knickachse soweit an die Verdrahtungsebene der mittels Drahtverschreibung miteinander verbundenen Leiterplattenabschnitte herangebracht, dass eine mechanische Beschädigung der Leitungsdrähte im Abwinkelungsbereich beim Abwinkeln ausgeschlossen und so eine zuverlässige elektrische Verbindung der einzelnen Leiterplattenabschnitte der Leiterplattenstruktur gewährleistet werden kann.

In einer weiteren bevorzugten Ausführungsform kann wenigstens der eine Leiterplattenabschnitt gegenüber einem anderen Leiterplattenabschnitt lagefixiert werden, wodurch sich eine stabile und mechanisch robuste räumliche Leiterplattenstruktur herstellen lässt.

In einer weiteren bevorzugten Ausführungsform kann die Drahtverschreibung mit den als Anschlussstellen vorgesehenen Bereichen auf einem dünnen, zumindest abschnittsweise leitfähigen Flächenelement, vorzugsweise einer leitfähigen Folie, vorgenommen werden, wobei das ebene, dünne, zumindest abschnittsweise leitfähige Flächenelement nach dessen Verdrahtung auf der Drahtverschreibungsseite zumindest abschnittsweise mittels eines Isolations- und Stabilisierungsmittels, welches vorzugsweise eine Armierungsschicht enthält, zur Herstellung einer Leiterplatte vergossen oder verpresst werden. Durch diesen Verfahrensschritt kann aus einem dünnen, zunächst mechanisch instabilen, leitfähigen Flächenelement wie beispielsweise einer leitfähigen Kupferfolie ein mechanisch stabiles und belastbares Leiterplattenprodukt hergestellt werden, das in vielfältiger Weise bearbeitet und bestückt werden kann.

In einer weiteren bevorzugten Ausführungsform kann das Leiterplattenmaterial entlang einer Abwinkelkante in einem plastischen Zustand abgewinkelt werden. Durch diesen Verfahrensschritt ist es möglich, eine einheitlich ausgeführte Leiterplattenträgerstruktur beispielsweise ohne Materialabtrag in eine räumliche Struktur umzuformen und hierbei ohne weitere Stabilisierungsmaßnahmen nach Eintreten der Verfestigung oder Aushärtung des Leiterplattenmaterials, z.B. durch Polymerisation, ein robustes und mechanisch stabiles Produkt zu erhalten.

In einer weiteren bevorzugten Ausführungsform kann die Abwinkelkante in einem plastischen Zustand der Leiterplatte eingeformt werden, wodurch sich in Großserienfertigung ein besonders einfaches und kostengünstiges, eine mechanische Nachbearbeitung vermeidendes Verfahren zur Gelenkigmachung der Leiterplattenstruktur erzielen lässt.

In einer weiteren bevorzugten Ausführungsform kann die Abwinkeikante durch Einbetten eines Fremdmaterials in das Isolations- und Stabilisierungsmaterial vor dessen Verfestigung oder Aushärtung hergestellt werden, wodurch sich beispielsweise eine Soll-Deformationslinie oder eine Trennfuge herstellen lässt und ein mechanisches Bearbeiten der Leiterplattenstruktur unterbleiben kann.

In einer weiteren bevorzugten Ausführungsform kann die Entfernung des Leiterplattenmaterials entlang der Abwinkelkante durch Laserabtrag erfolgen, wodurch sich eine sehr hohe Bearbeitungsgeschwindigkeit unter Vermeidung von Ablagerungen durch entferntes Material auf den verbleibenden Leiterplattenstrukturen erzielen lässt.

In einer weiteren bevorzugten Ausführungsform kann die Entfernung des Leiterplattenmaterials entlang der Abwinkelkante durch mechanischen Abtrag vorzugsweise mittels Fräsen oder Sägen erfolgen. Dies stellt einen sehr effizienten und produktionstechnisch flexiblen Weg zur Herstellung einer Abwinkelkante insbesondere im Klein- und Mittelserienbereich dar.

Erfindungsgemäß ist die Abwinkelnut nach Entfernen des Leiterplattenmaterials entlang der Abwinkelkante auf der Drahtverschreibungsseite in Gegenrichtung der Leiterplatte vom Leitungsdraht beabstandet, wobei über dem Leitungsdraht auf der Drahtverschreibungsseite 5% bis 30% der Leiterplattenstärke erhalten bleiben. Durch diese Ausführungsform lässt sich einerseits eine gute Stabilisierung des Abwinkelbereichs unter Vermeidung mechanischer Beschädigung der Leitungsdrähte durch Zerrung, Scherung oder Stauchung während des Abbiegens erzielen und andererseits eine hohe Sicherheit vor versehentlicher Beschädigung der im Abwinkelungsbereich verlaufenden Leitungsdrähte bei der Entfernung des Leiterplattenmaterials in der Abwinkelnut, selbst bei relativ hohen Fertigungstoleranzen und ohne zusätzliche Maßnahmen einfach und kostengünstig gewährleisten.

In einer weiteren bevorzugten Ausführungsform kann im Bereich der Abwinkelkante die leitfähige Folie vor dem Fräsen entfernt werden. Auf diese Weise kann zuverlässig die unerwünschte Bildung metallischen Abtrags bei der mechanischen Bearbeitung der Leiterplattenstruktur vermieden sowie eine Kontaktierung der leitfähigen Oberfächenbereiche der Leiterplattenstrukturen nach deren Abwinkeln unterbunden werden.

In einer weiteren bevorzugten Ausführungsform kann die Abwinkelung von der gefrästen Seite weg erfolgen. Auf diese Weise kann mit einem relativ schmalen Frässpalt und bei relativ geringer Frästiefe und somit bei relativ geringem Materialabtrag eine Gelenkstruktur geschaffen werden, die ein Abwinkeln der Leiterplattenabschnitte gegeneinander ohne Beschädigung des Leitungsdrahts ermöglicht und nach erfolgter Abwinklung gut zugänglich von der Außenseite mit einem Isolations- und Stabilisierungsmitteln verfüllt und mechanisch stabilisiert werden kann.

In einer weiteren bevorzugten Ausführungsform kann die Entfernung des Leiterplattenmaterials entlang einer Abwinkelkante vorzugsweise in Form einer V-Nut erfolgen und die Abwinklung in Richtung der gefrästen Seite vorgenommen wird. Wird eine 90° Abwinklung der Leiterplattenabschnitte der Leiterplattenstruktur angestrebt, so kann eine V-Nut mittels eines 90°-Kegelfräsers in das Leiterplattenmaterial eingefräst werden und so ein leicht mechanisch zu stabilisierender und mit einer Hohlkehlklebung zu versehender Haarspalt zwischen den einzelnen Leiterplattenabschnitten erzielt werden, wodurch sich eine sehr gute mechanische Stabilisierung erreichen lässt. Außerdem wäre es möglich, einen Fräser mit einem Spitzenwinkel von mehr als 90° einzusetzen, um im Fall einer 90°-Abwinklung der Leiterplattenabschnitte der Leiterplattenstruktur einen Trennspalt zwischen den einzelnen abgewinkelten Leiterplattenabschnitten einzuhalten, durch den eine bessere elektrische und thermische Trennung der Leiterplattenabschnitte erzielt werden kann.

In einer weiteren bevorzugten Ausführungsform kann das Isolations- und Stabilisierungsmittel zur Herstellung einer Leiterplatte eine Armierungsschicht aufweisen, die der Drahtverschreibung benachbart angeordnet ist und bei der Abwinklung der Leiterplattenabschnitte zumindest teilweise erhalten bleibt. Diese Ausführungsform kann bei den üblichen mechanisch zumeist durch eine Laminierung mit einer Armierungsschicht beispielsweise aus Glasfasergewebe stabilisierten Leiterplatten vorteilhaft sein, da hierbei das härtere und einen höheren Werkzeugverschleiß hervorrufende glasfasergewebe nicht mechanisch abgetragen werden muss und gleichzeitig ein sehr wirksames zugaufnehmendes und damit ein Einreißen des Gelenkbereichs wirksam verhinderndes Stabilisierungselement im Gelenkbereich zwischen den einzelnen Leiterplattenabschnitten der Leiterplattenstruktur erhalten bleibt, das einerseits die Leitungsdrähte beim Abwinkeln der Leiterplattenabschnitte vor mechanischer Beschädigung schützt und andererseits eine weitaus bessere mechanische Stabilisierung des Abwinklungsbereichs nach Verfüllen der Abwinkelnut mit einem Isolations- und Stabilisierungsmittel möglich macht. Außerdem hält die Armierungsschicht die verlegten Leitungsdrähte zuverlässig nieder und schützt diese so vor unerwünschter Beschädigung beim Materialabtrag entlag der Abwinkelkante.

In einer weiteren bevorzugten Ausführungsform kann die Abwinkelnut entlang der Abwinkelkante mit einem Isolations- und Stabilisierungsmittel versehen werden. Hierdurch können die Leiterplattenabschnitte der Leiterplattenstruktur nach deren Abwinkelung elektrisch voneinander isoliert und mechanisch stabilisiert zu einer funktionsfähigen räumlichen Leiterplattenstruktur verbunden werden.

In einer weiteren bevorzugten Ausführungsform können aus wenigstens einem Leiterplattenabschnitt wenigstens zwei weitere Leiterplattenabschnitte hergestellt werden. Auf diese Weise ist es z.B. möglich, ein U-förmiges räumliches Leiterplattengebilde mit zwei parallelen, doppelseitig bestückbaren Bestückungsebenen zu schaffen, die elektrisch und thermisch sehr gut voneinander getrennt oder entkoppelt sind.

In einer weiteren bevorzugten Ausführungsform können, ausgehend von der ebenen Leiterplatte, wenigstens sechs Leiterplattenabschnitte derart abgewinkelt werden, dass sie die Seitenflächen eines geschlossenen Gehäuses bilden. Eine solche Struktur ist sehr kompakt und mechanisch robust und bietet eine Reihe wichtiger Vorteile. Auf diese Weise ist es möglich, Bauteile geschützt beispielsweise vor kondensierender Feuchtigkeit, Chemikalien oder anderen schädlichen Einflüssen oder starken Temperaturschwankungen im Inneren des Gehäuses unterzubringen. Hierbei können die im Inneren des Leiterplattengehäuses untergebrachten Bauelemente der Schaltung vor wechselnden Umwelteinflüssen geschützt und ggf. auch temperiert und vor Zugluft abgeschirmt und so Beeinträchtigungen der Funktion und Genauigkeit oder vorzeitige Alterung verhindert werden. Ein weiterer sehr wichtiger Aspekt liegt in der elektrostatischen und elektromagnetischen Schirmung, im sogenannten "EGB-Schutz" von elektrostatisch sensitiven Bauteilen sowie im Hochspannungsschutz von Menschen und elektronischen Komponenten. Weiterhin kann auf diese Weise auch der unerwünschte Einblick, Zugriff oder Reparaturversuch durch unbefugte Personen wirksam unterbunden werden. Außerdem entstehen auf diese Weise sehr kompakte, robuste und mechanisch hochbelastbare Leiterplattenstrukturen, die sich durch eine sehr hohe Zuverlässigkeit Leitungsverbindungen zwischen den einzelnen Leiterplattenabschnitten und eine sehr geringe Fehlerrate bei der Herstellung und Ausfallrate im Einsatz auszeichnen. In einer weiteren bevorzugten Ausführungsform kann die eine ebene Leiterplatte wenigstens auf ihrer zum Leitungsdraht weisenden Seite vor dem Abwickeln mit wenigstens einer Deckschicht aus Isolierstoffmaterial versehen werden. Auf diese Weise kann eine zusätzliche sinnvolle elektrische Isolationsschicht aufgebracht werden.

Die von den einzelnen Leiterplattenabschnitten im Bereich der Abwinkelkanten wegragenden Leitungsdrähte können an den Leiterplattenabschnitten dadurch fixiert und geschützt sein, dass die drahtbeschriebene Leiterplatte vor dem Abwinkeln wenigstens auf ihrer zu den Leitungsdrähten weisenden Seite mit wenigstens einer Deckschicht aus Isolierstoffmaterial versehen wird. Bedingt durch das Herstellverfahren kontaktieren sich die Leiterplattenabschnitte dann entlang der Abwinkelkante oder liegen sich dort zumindest unmittelbar gegenüber, wobei sich die Leitungsdrähte über die Abwinkelkanten erstrecken und jeweils beidseitig zwischen dem betreffenden Leiterplattenabschnitt und der wenigstens einen Deckschicht aus Isolierstoffmasse stoffschlüssig eingebettet sind.

In einer weiteren bevorzugten Ausführungsform können an zumindest einigen der Anschlussstellen elektrische oder elektronische Bauelemente vor- oder nach dem Abwinkein angeschlossen werden. Hierdurch ergeben sich eine Reihe von Optimierungsmöglichkeiten für den Herstellungsprozess, wobei z.B. im ebenen Zustand Bestückungsvorgänge mit mechanischen, elektrischen und elektronischen Bauelementen, Abgleichen, Schaltungsprüfung, Fehlersuche und eventuelle Reparaturen zumeist sehr viel einfacher und ohne Behinderung durch räumliche Strukturen im ebenen Zustand der Leiterplatte durchgeführt werden. Andererseits kann es zweckmäßig sein, besonders empfindliche oder auf der Außenseite der abgewinkelten Struktur angebrachte Bauelemente zunächst noch nicht zu bestücken, um sie vor Beschädigung bei der mechanischen Bearbeitung der Leiterplattenstruktur zu schützen.

Gemäß dem Vorrichtungsaspekt bezieht sich die Erfindung auf eine abwinkelbare Leiterplattenstruktur aus wenigstens zwei zueinander winkelig anordenbaren Leiterplattenabschnitten, dadurch gekennzeichnet, dass diese wenigstens in einem zumindest überwiegend in der Leiterplatten eingebetteten Leitungsdraht enthält, der sich zwischen zwei als Anschlussstellen vorgesehenen Bereichen der Leiterplatte erstreckt und mit diesen elektrisch leitend verbunden ist, wobei sich die beiden als Anschlussstellen vorgesehenen Bereiche auf verschiedenen Leiterplattenabschnitten befinden, wobei die Leiterplattenabschnitte unter Beibehaltung der Verbindung der als Anschlussstellen vorgesehenen Bereiche durch den wenigstens einen Leitungsdraht und unter Biegung des Leitungsdrahtes gegeneinander abwinkelbar sind. Eine solche Leiterplattenstruktur kann durch sämtliche der vorerwähnten Verfahrensvarianten hergestellt und so mit spezifischen Eigenschaften versehen werden, wobei auch mehrere dieser Aspekte sinnvoll miteinander zu kombinieren sind. Das daraus resultierende Produkt der abwinkelbaren Leiterplattenstruktur kann dadurch mit dem zuvor im Zusammenhang mit den Verfahrensschritten diskutierten Eigenschaften und Vorteilen versehen werden und so an die Spezifikantionsvorgaben bestmöglich angepasst werden.

Weiterhin kann im Rahmen der vorliegenden Erfindung eine Ausführungsform als räumliche Leiterplattenstruktur aus wenigstens zwei zueinander winkelig angeordneten Leiterplattenabschnitten geschaffen werden, wobei die Leiterplattenabschnitte durch wenigstens einen Leitungsdraht miteinander in elektrisch leitender Verbindung stehen, wobei sich die Leiterplattenabschnitte entlang einer Abwinkelkante kontaktieren, oder sich dort unmittelbar gegenüberliegen, wobei sich der Leitungsdraht über die Abwinkelkante erstreckt und beidseitig zwischen dem betreffenden Leiterplattenabschnitt und wenigstens einer Deckschicht aus Isolierstoffmasse stoffschlüssig eingebettet ist.

Die von den einzelnen Leiterplattenabschnitten im Bereich der Abwinkelkanten wegragenden Leitungsdrähte können an den Leiterplattenabschnitten dadurch fixiert und geschützt sein, dass die drahtbeschriebene Leiterplatte vor dem Abwinkeln wenigstens auf ihrer zu den Leitungsdrähten weisenden Seite mit wenigstens einer Deckschicht aus Isolierstoffmaterial versehen wird. Bedingt durch das Herstellverfahren kontaktieren sich die Leiterplattenabschnitte dann entlang der Abwinkelkante oder liegen sich dort zumindest unmittelbar gegenüber, wobei sich die Leitungsdrähte über die Abwinkelkanten erstrecken und jeweils beidseitig zwischen dem betreffenden Leiterplattenabschnitt und der wenigstens einen Deckschicht aus Isolierstoffmasse stoffschlüssig eingebettet sind. Auf diese Weise lässt sich eine sehr kostengünstige und praxistaugliche räumliche Leiterplattenstruktur herstellen.

In einer weiteren bevorzugten Ausführungsform können die Leiterplattenabschnitte gegeneinander lagefixiert sein, was mittels Verfüllen der Trennfuge und/oder des Abwinkelungsbereichs der abgewinkelten Leiterplattenabschnitte mittels eines Isolations- und Stabilisierungsmittels mit oder ohne Armierungsbeigaben erfolgen kann, oder durch Vergießen oder durch Verbinden mit räumlichen Stabilisierungsstrukturen beispielsweise durch Verklebung, oder durch Befestigung der Leiterplattenabschnitte der Leiterplat- ' tenstruktur am Einbauort.

Die vorstehend ausgeführten Ausgestaltungen der Erfindung stellen lediglich eine Auswahl zweckmäßiger Gestaltungsmöglichkeiten des Erfindungsgegenstandes dar, die in den einzelnen Unteransprüchen niedergelegt sind. Diese speziellen Gestaltungsmöglichkeiten können einzeln oder, soweit technisch möglich und sinnvoll, auch in Kombination mehrerer der vorerwähnten Gestaltungsvarianten mit einem Verfahren gemäß dem Anspruch 1 bzw. einer Vorrichtung nach Anspruch 26 Anwendung finden.

Nachfolgend wird die Erfindung beispielhaft anhand bevorzugter Ausführungsbeispiele in Verbindung mit den dazugehörigen Figuren näher erläutert. Es zeigen:
- Fig. 1: eine perspektivische Ansicht auf eine Leiterplatte, auf welcher eine elektrische Schaltung mit mehreren elektrisch leitfähigen Leitungsdrähten angeordnet ist;
- Fig. 2: die Leiterplatte von Fig. 1, von welcher Leiterplattenabschnitte winklig wegragen;
- Fig. 3: die Leiterplatte von Fig. 1, von welcher die Leiterplattenabschnitte zu einem geschlossenen Gehäuse zusammengesetzt worden sind;
- Fig. 4: eine detailliertere perspektivische Schnittdarstellung einer Leiterplatte mit mehreren Anschlussbereichen in abgewinkeltem Zustand mit teilweise verfüllter Abwinkelungsfuge;
- Fig. 5a: Schnittdarstellung durch eine Leiterplatte mit Leitungsdrahtverbindung mit durch Fräsung eingebrachter Abwinkelnut;
- Fig. 5b: Schnittdarstellung durch eine Leiterplatte mit Leitungsdrahtverbindung mit mittels Sägens entlang der Abwinkelkante teilweise entferntem Leiterplattenmaterial.

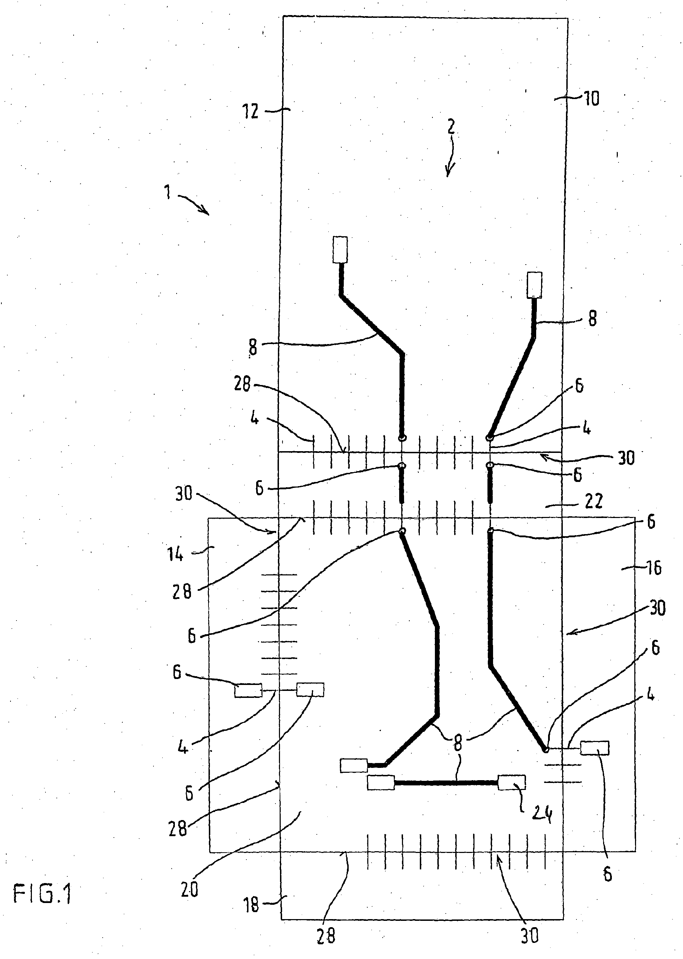

Bei der in Fig. 1 insgesamt mit 1 bezeichneten elektrisch isolierenden Leiterplatte ist eine elektrische oder elektronische Schaltung verwirklicht, welche neben an der Leiterplattenoberfläche verlaufenden elektrischen Leiterbahnen 8 auch elektrisch leitfähige Leitungsdrähte 4 beinhaltet, welche im Inneren der Leiterplatte angeordnet sind. Die Leitungsdrähte 4 kontaktieren an definierten, beispielsweise durch Ätzung einer mit der Oberfläche der Leiterplatte verbundenen Kupferfolie erzeugten Anschlussstellen 6 die Leiterplatte 1. Diese Kontaktierung der Leitungsdrähte 4 mit der Kupferfolie erfolgt beispielsweise durch Schweißung, Bonden, Löten, Lötkleben oder dergleichen. Die Leitungsdrähte 4 sind beispielsweise mit einer Isolierung versehen um die Leitungsdrähte 4 in mehreren Ebenen übereinander anordnen zu können. Nach erfolgter Verdrahtung der Kupferfolie mit den Leitungsdrähten 4 kann die Kupferfolie beispielsweise durch Verpressung mit einem stabilisierenden Flächenelement eine ebene Leiterplatte bilden. Der Aufbau und die Herstellung einer solchen drahtbeschriebenen Leiterplatte 1 ist beispielsweise aus der DE 101 08 168 C1 bekannt. So kann eine Multiwire-Leiterplatte unter Anwendung eines Drahtschreibeverfahrens hergestellt werden, wobei auf der Innenseite eines dünnen Flächenelements aus elektrisch leitendem Material, vorzugsweise einer Kupferfolie, der Drahtverschreibung entsprechende Leitungsdrähte definiert verlegt und an definierten Kontaktstellen des dünnen leitfähigen Flächenelements beispielsweise durch Verschweißung kontaktiert und festgelegt werden. Anschließend wird auf der Innenseite des dünnen leitfähigen Flächenelements mit den kontaktierten Leitungsdrähten ein Stabilisierungsflächenelement festgelegt. Dies kann beispielsweise durch Verpressen mittels eines Prepregs oder Vergießen einer Armierungsschicht, beispielsweise mittels eines Kunstharzes und anschließendem Aushärten des Verbundes geschehen. Danach wird das dünne Flächenelement beispielsweise durch partielles Abätzen von seiner Außenseite her derartig strukturiert, dass die Kontaktstellen vom übrigen Flächenelement getrennt und somit elektrisch voneinander isoliert werden.

Die drahtbeschriebene Leiterplatte 1 weist beispielsweise zusätzlich geätzte Leiterbahnen 8 auf, welche mit den Anschlussstellen 6 elektrisch verbunden sind. Die Leiterplatte 1 kann weiterhin auf ihrer zu den Leitungsdrähten 6 weisenden Seite mit einer aushärtbaren elektrischen Isoliermasse als Deckschicht 10 und beispielsweise einer Armierungsschicht z.B. aus Glasfasergewebe in Verbundbauweise vergossen sein. Die Leitungsdrähte 4 und die Leiterbahnen 8 sind in Verdrahtungsebenen auf der Oberseite der Leiterplatte 1 angeordnet (Leiterbahnen 8) bzw. dort eingegossen (Leitungsdrähte 4). Im vorliegenden Fall ist folglich auf der einzelnen Leiterplatte 1 eine Kombination von geätzten Leiterbahnen 8 und Drahtverbindungen mit Leitungsdrähten 4 verwirklicht. Dabei sind die geätzten Leiterbahnen 8 auf Leiterplattenabschnitten 12, 14, 16, 18, 20, 22 der Leiterplatte derart verteilt angeordnet, dass sich zwischen den einzelnen Leiterplattenabschnitten 12, 14, 16, 18, 20, 22 lediglich die Leitungsdrähte 4 erstrecken, aber keine geätzten Leiterbahnen 8. Genauso kann aber auch innerhalb eines Leiterplattenabschnittes 12, 14, 16, 18, 20, 22 eine elektrische Verschaltung verwirklicht sein, welche Leitungsdrähte enthält, die nur diesem Leiterplattenabschnitt 12, 14, 16, 18, 20, 22 zugeordnet sind. Weiterhin können an zumindest einigen der Anschlussstellen 6 elektrische oder elektronische Bauelemente vor- und/oder nach dem Abwinkeln angeschlossen werden.

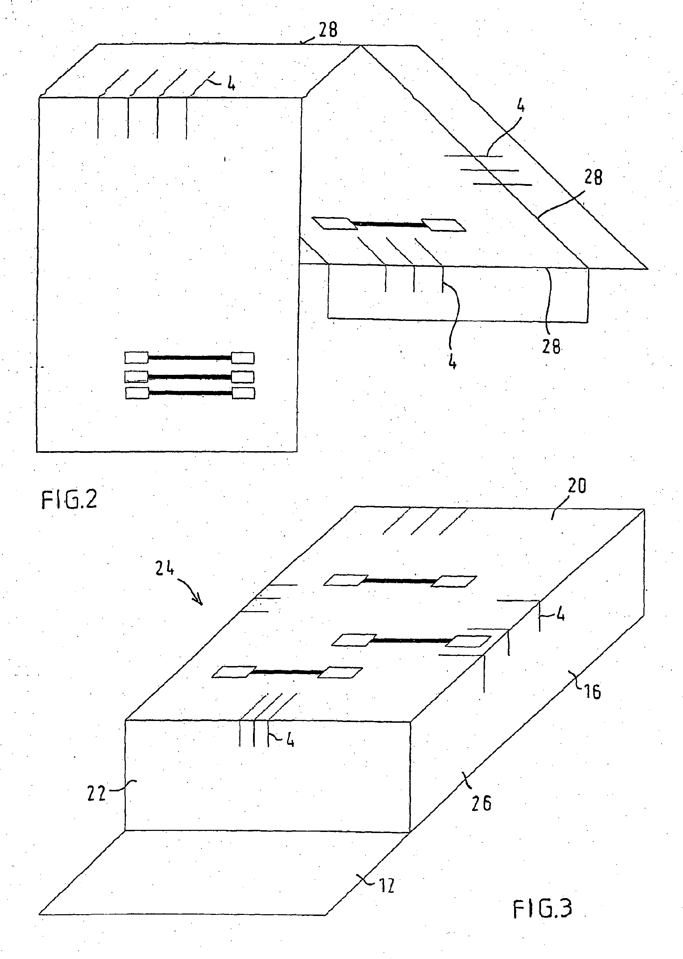

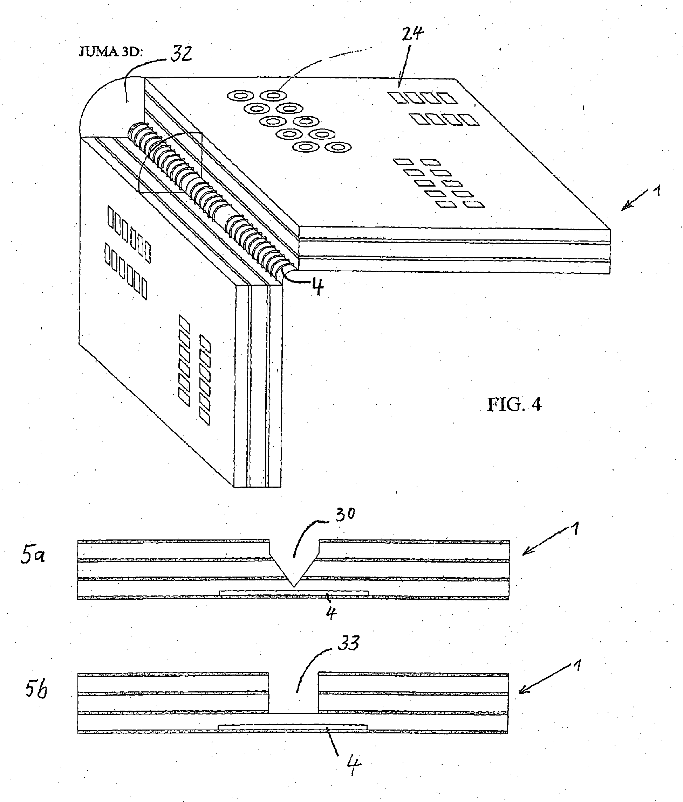

Zur Herstellung einer räumlichen Leiterplattenstruktur 24 beispielsweise in Form eines geschlossenen Gehäuses 26 gemäß Figur 3 werden ausgehend von einem Basisleiterplattenabschnitt 12 an definierten Abwinkelkanten 28 zwischen den sechs Leiterplattenabschnitten 12, 14, 16, 18, 20, 22 gemäß eines weiteren Fertigungsschritts, vorzugsweise quer zur Verlaufsrichtung der zwischen den Leiterplattenabschnitten 12,14, 16, 18, 20, 22 verlaufenden Leitungsdrähte 4, Nuten 30, 33 in das Leiterplattenmaterial bzw. in das isolierstoffmaterial der Deckschicht 10 der Leiterplatte 1 beispielsweise eingefräst (30, Fig. 5a) oder eingesägt (33, Fig. 5b). Hierbei wird darauf geachtet, dass die die Leiterplattenabschnitte 12, 14, 16, 18, 20, 22 verbindenden Leitungsdrähte 4 nicht beschädigt werden. Dabei ist es möglich, über den Leitungsdrähten 4 auf der Verdrahtungsseite einige hundert µm Leiterplattenmaterial stehen zu lassen, um die Gefahr der Beschädigung der Leitungsdrähte auszuschließen und eine bessere mechanische Stabilisierung des Schamierbereichs zu gewährleisten. Wie oben beschrieben, sind die geätzten Leiterbahnen 8 bereits derart auf den Leiterplattenabschnitten 12, 14, 16, 18, 20, 22 angeordnet, dass sie durch den Fräsvorgang entlang der Trennlinien zwischen den Leiterplattenabschnitten 12, 14, 16, 18, 20, 22 darstellenden Abwinkelkanten 28 nicht unterbrochen werden können. Das heißt, jedem Leiterplattenabschnitt 12, 14, 16, 18, 20, 22 ist eine eigene Leiterbahnstruktur und/oder Leitungsdrahtstruktur zugeordnet, welche nur durch Leitungsdrähte mit den Leiterbahnstrukturen und/oder Leitungsdrahtstrukturen eines anderen Leiterplattenabschnitts 12, 14, 16, 18, 20, 22 in elektrisch leitender Verbindung steht.

Dann werden die Leiterplattenabschnitte 12, 14, 16, 18, 20, 22 entlang der Abwinkelkanten 28, ähnlich wie bei der Herstellung eines Verpackungs- oder Umzugskartons in Form eines geschlossenen Gehäuses 26 geklappt, wie aus Fig. 2 hervorgeht. Die Leitungsdrähte 4 fungieren dabei als flexible Gelenkelemente, da sie neben der elektrischen auch eine mechanische Verbindung zwischen den Leiterplattenabschnitten 12, 14, 16, 18, 20, 22 herstellen und andererseits biegsam sind (siehe Fig. 4). Ebenso ist es möglich, durch nichtabgetragenes Leiterplattenmaterial und eventuell ebenfalls nicht abgetragene Teile einer in den Leiterplattenträger eingebetteten Armierungsschicht den Gelenkbereich zwischen den Leiterplattenabschnitten 12, 14, 16, 18, 20, 22 mechanisch zu verstärken und die Leitungsdrähte 4 vor Beschädigung beim Einbringen der Nut entlang der Abwinkelkante zu schützen und beim Abknickvorgang vor Überdehnung, Überscherung oder Überstauchung zu vermeiden. Die Leiterplattenabschnitte 12, 14, 16, 18, 20, 22 können sich beispielsweise entlang der Abwinkelkanten kontaktieren und die zwischen diesen verlaufenden Leitungsdrähte sind dann jeweils beidseitig zwischen dem betreffenden Leiterplattenabschnitt 12, 14, 16, 18, 20, 22 und der Deckschicht 10 aus Isolierstoffmasse stoffschlüssig eingebettet und erstrecken sich über die jeweilige Abwinkelkante 28.

Schließlich werden die Leiterplattenabschnitte 12, 14, 16, 18, 20, 22 gegeneinander lagefixiert, beispielsweise durch Klebung oder Verfüllung 32 der Abwinkelungsfuge oder Anbringen von Winkeln, um ein steifes, geschlossenes Gehäuse 26 gemäß Fig. 3 zu bilden, dessen Wände ausschließlich durch die Leiterplattenabschnitte 12, 14, 16, 18, 20, 22 gebildet werden. Dabei kann der Basisleiterplattenabschnitt 12 beispielsweise seitlich über den Querschnitt des Gehäuses 26 hinausragen, um genügend Fläche für externe Anschlüsse zur Verfügung zu stellen.

Zur Herstellung einer erfindungsgemäßen Leiterplattenstruktur ist es möglich, z.B. auf einer Trägerschicht angeordnete, diskrete Anschlussstellen und Leitungsstrukturen mittels Drahtverschreibung miteinander zu verbinden und daraus eine entsprechende Leiterplatte, beispielsweise durch Verkleben oder Verpressen mit einem Stabilisierungsflächenelement herzustellen. Alternativ ist es möglich, nach dem Verlegen bzw. Drahtschreiben der Leitungsdrähte 4, aber noch vor dem Abwinkeln der fertigen Leiterplatte 1 die auf der Oberfläche der ebenen Leiterplatte 1 befestigte Kupferfolie zu ätzen, um die Anschlussstellen 6 aus der Kupferfolie herauszuarbeiten und diese von anderen Bereichen der Kupferfolie zu trennen und elektrisch gegeneinander zu isolieren. Da die Anschlussstellen jedoch gemäß des vorhandenen Schaltungslayouts bereits vorab bekannt sind, können die Verbindungen der Leitungsdrähte 4 mit den eigentlich noch nicht vorhandenen Anschlussstellen 6 bereits vorab gefertigt und mittels Drahtschreibung miteinander verdrahtet werden. Anschließend kann dann die mit den Leitungsdrähten 4 versehene Oberfläche der Leiterplatte 1 mit einer mechanisch stabilisierenden und elektrisch isolierenden Schicht 10 verbunden werden, indem beispielsweise ein Prepreg aus Isolierstoffmasse mit darin eingebetteten Armierungsgewebe mit der Leiterplatte 1 verpresst wird.

## Patentansprüche

1. Verfahren zur Herstellung einer abwinkelbaren drahtbeschriebenen Leiterplattenstruktur aus zumindest zwei Leiterplattenabschnitten (12, 14, 16, 18, 20, 22) mit folgenden Schritten:
a) Herstellen einer ebenen Leiterplatte (1) mit geätzten Leiterbahnen (8) und mit wenigstens einem zumindest überwiegend in der Leiterplatte (1) eingebetteten Leitungsdraht (4), der sich zwischen zwei als Anschlussstellen (6) vorgesehenen Bereichen der Leiterplatte (1) erstreckt und mit diesen elektrisch leitend verbunden ist, wobei sich die beiden als Anschlussstellen (6) vorgesehenen Bereiche auf verschiedenen Leiterplattenabschnitten (12, 14, 16, 18, 20, 22) befinden;
b) Bereitstellen mindestens einer Abwinkelkante (28) zwischen den Leiterplattenabschnitten (12, 14, 16, 18, 20, 22), wobei die Abwinkelkante (28) durch teilweises Entfernen von Leiterplattenmaterial hergestellt wird und entlang der Abwinkelkante (28) die Stärke der Leiterplatte (1) gegenüber angrenzenden Bereichen verringert ist, wobei eine Abwinkelnut (30) nach Entfernen des Leiterplattenmaterials entlang der Abwinkelkante (28) auf der Drahtverschreibungsseite in Gegenrichtung der Leiterplatte (1) vom Leitungsdraht (4) beabstandet ist und über dem Leitungsdraht (4) auf der Drahtverschreibungsseite bis 30% der Leiterplattenstärke erhalten bleiben, so dass die Leiterplattenabschnitte (12, 14, 16, 18, 20, 22) unter Beibehaltung der Verbindung der als Anschlussstellen (6) vorgesehenen Bereiche durch den wenigstens einen Leitungsdraht (4) und unter Biegung des wenigstens einen Leitungsdrahts (4) gegeneinander abwinkelbar sind.

2. Verfahren zum Herstellen einer abwinkelbaren Leiterplattenstruktur nach Anspruch 1-, **dadurch gekennzeichnet, dass** die Leiterplatte (1) mit elektrischen Anschlussstellen (6) versehen wird.

3. Verfahren zum Herstellen einer abwinkelbaren Leiterplattenstruktur nach zumindest einem der Ansprüche 1 oder 2, **dadurch gekennzeichnet, dass** der Leitungsdraht (4) mittels Drahtschreibung aufgebracht und mit den als Anschlussstellen (6) vorgesehenen Bereichen der Leiterplatte (1) vorzugsweise verschweisst wird.

4. Verfahren zum Herstellen einer abwinkelbaren Leiterplattenstruktur nach zumindest einem der vorangegangenen Ansprüche, **dadurch gekennzeichnet, dass** entlang der Abwinkelkante (28) die Steifigkeit und/oder Festigkeit der Leiterplatte (1) gegenüber angrenzenden Bereichen herabgesetzt ist.

5. Verfahren zum Herstellen einer abwinkelbaren Leiterplattenstruktur nach einem der vorangehenden Ansprüche, **dadurch gekennzeichnet, dass** nach dem teilweisen Entfernen von Leiterplattenmaterial wenigstens ein Leiterplattenabschnitt (12, 14, 16, 18, 20, 22) gegenüber wenigstens einem anderen Leiterplattenabschnitt (12, 14, 16, 18, 20, 22) unter Beibehaltung der Verbindung der als Anschlussstellen (6) vorgesehenen Bereiche durch den wenigstens einen Leitungsdraht (4) und unter Biegung des wenigstens einen Leitungsdrahtes (4) abgewinkelt wird.

6. Verfahren zum Herstellen einer abwinkelbaren Leiterplattenstruktur nach einem der vorangehenden Ansprüche, **dadurch gekennzeichnet, dass** wenigstens der eine Leiterplattenabschnitt (12, 14, 16, 18, 20, 22) gegenüber einem anderen Leiterplattenabschnitt (12, 14, 16, 18, 20, 22) lagefixiert wird.

7. Verfahren zum Herstellen einer abwinkelbaren Leiterplattenstruktur nach einem der vorangehenden Ansprüche, **dadurch gekennzeichnet, dass** die Drahtverschreibung mit den als Anschlussstellen (6) vorgesehenen Bereichen auf einem dünnen zumindest abschnittsweise leitfähigen Flächenelement, vorzugsweise einer leitfähigen Folie vorgenommen wird, wobei das ebene, dünne zumindest abschnittsweise leitfähige Flächenelement nach dessen Verdrahtung auf der Drahtverschreibungsseite zumindest abschnittsweise mittels eines Isolations- und Stabilisierungsmittels, welches vorzugsweise eine Armierungsschicht enthält, zur Herstellung einer Leiterplatte (1) vergossen oder verpresst wird.

8. Verfahren zum Herstellen einer abwinkelbaren Leiterplattenstruktur nach einem der vorangehenden Ansprüche, **dadurch gekennzeichnet, dass** das Leiterplattenmaterial entlang der Abwinkelkante (28) in einem plastischen Zustand abgewinkelt wird.

9. Verfahren zum Herstellen einer abwinkelbaren Leiterplattenstruktur nach einem der vorangehenden Ansprüche, **dadurch gekennzeichnet, dass** die Entfernung des Leiterplattenmaterials entlang der Abwinkelkante (28) durch Laserabtrag erfolgt.

10. Verfahren zum Herstellen einer abwinkelbaren Leiterplattenstruktur nach einem der vorangehenden Ansprüche, **dadurch gekennzeichnet, dass** die Entfernung des Leiterplattenmaterials entlang der Abwinkelkante (28) durch mechanischen Abtrag vorzugsweise mittels Fräsen oder Sägen erfolgt.

11. Verfahren zum Herstellen einer abwinkelbaren Leiterplattenstruktur nach einem der vorangehenden Ansprüche, **dadurch gekennzeichnet, dass** im Bereich der Abwinkelkante (28) die leitfähige Folie vor dem Fräsen entfernt ist.

12. Verfahren zum Herstellen einer abwinkelbaren Leiterplattenstruktur nach einem der vorangehenden Ansprüche, **dadurch gekennzeichnet, dass** die Abwinkelung von der gefrästen Seite weg erfolgt.

13. Verfahren zum Herstellen einer abwinkelbaren Leiterplattenstruktur nach einem der vorangehenden Ansprüche, **dadurch gekennzeichnet, dass** diese Entfernung des Leiterplattenmaterials entlang der Abwinkelkante (28) vorzugsweise in Form einer V-Nut (30) erfolgt und die Abwinkelung in Richtung der gefrästen Seite vorgenommen wird.

14. Verfahren zum Herstellen einer abwinkelbaren Leiterplattenstruktur nach einem der vorangehenden Ansprüche, **dadurch gekennzeichnet, dass** das Isolationsund Stabilisierungsmittel zur Herstellung einer Leiterplatte (1) eine Armierungsschicht aufweist, die der Drahtverschreibung benachbart angeordnet ist und bei der Bearbeitung der Leiterplattenstruktur und der Abwinkelung der Leiterplattenabschnitte (12, 14, 16, 18, 20, 22) zumindest teilweise erhalten bleibt.

15. Verfahren zum Herstellen einer abwinkelbaren Leiterplattenstruktur nach einem der vorangehenden Ansprüche, **dadurch gekennzeichnet, dass** ausgehend von der ebenen Leiterplatte (1) wenigstens sechs Leiterplattenabschnitte (12, 14, 16, 18, 20, 22) derart abgewinkelt werden, das sie die Seitenflächen eines geschlossenen Gehäuses (26) bilden.

16. Verfahren zum Herstellen einer abwinkelbaren Leiterplattenstruktur nach einem der vorangehenden Ansprüche, **dadurch gekennzeichnet, dass** die ebene Leiterplatte (1) wenigstens auf ihrer zum Leitungsdraht (4) weisenden Seite vor dem Abwinkeln mit wenigstens einer Deckschicht (10) aus Isolierstoffmaterial versehen wird.

17. Verfahren zum Herstellen einer abwinkelbaren Leiterplattenstruktur nach einem der vorangehenden Ansprüche, **dadurch gekennzeichnet, dass** an zumindest einigen der Anschlussstellen (6) elektrische oder elektronische Bauelemente vor oder nach dem Abwinkeln angeschlossen werden.

18. Abwinkelbare drahtbeschriebene Leiterplattenstruktur aus wenigstens zwei zueinander winkelig anordenbaren Leiterplattenabschnitten (12, 14, 16, 18, 20, 22), die geätzte Leiterbahnen (8) und wenigstens einen zumindest überwiegend in der Leiterplattenstruktur (1) eingebetteten Leitungsdraht (4) enthält, der sich zwischen zwei als Anschlussstellen (6) vorgesehenen Bereichen der Leiterplattenstruktur (1) erstreckt und mit diesen elektrisch leitend verbunden ist, wobei sich die beiden als Anschlussstellen (6) vorgesehenen Bereiche auf verschiedenen Leiterplattenabschnitten (12, 14, 16, 18, 20, 22) befinden, und eine durch teilweises Entfernen von Leiterplattenmaterial hergestellte Abwinkelkante (28) vorgesehen ist, entlang der die Stärke der Leiterplatte (1) gegenüber angrenzenden Bereichen verringert ist, wobei eine Abwinkelnut (30) nach Entfernen des Leiterplattenmaterials entlang der Abwinkelkante (28) auf der Drahtverschreibungsseite in Gegenrichtung der Leiterplatte (1) vom Leitungsdraht (4) beabstandet ist und über dem Leitungsdraht (4) auf der Drahtverschreibungsseite bis 30% der Leiterplattenstärke erhalten bleiben, so dass die Leiterplattenabschnitte unter Beibehaltung der Verbindung der als Anschlussstellen (6) vorgesehenen Bereiche durch den wenigstens einen Leitungsdraht (4) und unter Biegung des wenigstens einen Leitungsdrahtes (4) gegeneinander abwinkelbar sind.

## Claims

1. Method for producing a wire-written printed circuit board structure which is capable of being angled and composed of at least two printed circuit board sections (12, 14, 16, 18, 20, 22), comprising the following steps:
a) producing a flat printed circuit board (1) comprising etched traces (8) and comprising at least one conducting wire (4) which is at least predominantly embedded in the printed circuit board (1), which conducting wire extends between two regions of the printed circuit board (1) that are provided as connection points (6) and is connected to said connection points in an electrically conductive manner, wherein the two regions that are provided as connection points (6) are located on different printed circuit board sections (12, 14, 16, 18, 20, 22);
b) providing at least one angling edge (28) between the printed circuit board sections (12, 14, 16, 18, 20, 22), wherein the angling edge (28) is produced by partially removing printed circuit board material and the thickness of the printed circuit board (1) is reduced along the angling edge (28) in comparison to adjoining regions, wherein an angling groove (30), after removing the printed circuit board material along the angling edge (28) on the wire writing side, is spaced apart from the conducting wire (4) in the opposite direction of the printed circuit board (1) and up to 30% of the printed circuit board thickness is retained over the conducting wire (4) on the wire writing side, so that the printed circuit board sections (12, 14, 16, 18, 20, 22) can be angled relative to one another while maintaining the connection of the regions that are provided as connection points (6) by means of the at least one conducting wire (4) and by bending the at least one conducting wire (4).

2. Method for producing a printed circuit board structure capable of being angled according to claim 1, **characterized in that** the printed circuit board (1) is provided with electrical connection points (6).

3. Method for producing a printed circuit board structure capable of being angled according to at least one of claims 1 or 2, **characterized in that** the conducting wire (4) is applied by means of wire writing and is preferably welded to the regions of the printed circuit board (1) that are provided as connection points (6).

4. Method for producing a printed circuit board structure capable of being angled according to at least one of the preceding claims, **characterized in that** the stiffness and/or strength of the printed circuit board (1) is reduced along the angling edge (28) in comparison to adjoining regions.

5. Method for producing a printed circuit board structure capable of being angled according to any of the preceding claims, **characterized in that**, after the partial removal of printed circuit board material, at least one printed circuit board section (12, 14, 16, 18, 20, 22) is angled relative to at least one other printed circuit board section (12, 14, 16, 18, 20, 22) while maintaining the connection of the regions that are provided as connection points (6) by means of the at least one conducting wire (4) and by bending the at least one conducting wire (4).

6. Method for producing a printed circuit board structure capable of being angled according to any of the preceding claims, **characterized in that** at least one printed circuit board section (12, 14, 16, 18, 20, 22) is fixed in position relative to another printed circuit board section (12, 14, 16, 18, 20, 22).

7. Method for producing a printed circuit board structure capable of being angled according to any of the preceding claims, **characterized in that** the wire writing comprising the regions that are provided as connection points (6) is carried out on a thin surface element that is conductive at least in some sections, preferably a conductive film, wherein, after being wired, the flat, thin surface element that is conductive at least in some sections is encapsulated or compressed on the wire writing side at least in some sections by means of an insulating and stabilising agent, which preferably contains a reinforcement layer, so as to produce a printed circuit board (1).

8. Method for producing a printed circuit board structure capable of being angled according to any of the preceding claims, **characterized in that** the printed circuit board material is angled along the angling edge (28) in a plastic state.

9. Method for producing a printed circuit board structure capable of being angled according to any of the preceding claims, **characterized in that** the removal of the printed circuit board material along the angling edge (28) takes place by laser ablation.

10. Method for producing a printed circuit board structure capable of being angled according to any of the preceding claims, **characterized in that** the removal of the printed circuit board material along the angling edge (28) takes place by mechanical ablation, preferably by means of milling or sawing.

11. Method for producing a printed circuit board structure capable of being angled according to any of the preceding claims, **characterized in that**, in the region of the angling edge (28), the conductive film is removed prior to the milling.

12. Method for producing a printed circuit board structure capable of being angled according to any of the preceding claims, **characterized in that** the angling takes place away from the milled side.

13. Method for producing a printed circuit board structure capable of being angled according to any of the preceding claims, **characterized in that** this removal of the printed circuit board material along the angling edge (28) takes place preferably in the form of a V-shaped groove (30) and the angling is carried out towards the milled side.

14. Method for producing a printed circuit board structure capable of being angled according to any of the preceding claims, **characterized in that** the insulating and stabilizing agent for producing a printed circuit board (1) comprises a reinforcement layer which is arranged adjacent to the wire writing and is at least partially retained during the machining of the printed circuit board structure and the angling of the printed circuit board sections (12, 14, 16, 18, 20, 22).

15. Method for producing a printed circuit board structure capable of being angled according to any of the preceding claims, **characterized in that**, starting from the flat printed circuit board (1), at least six printed circuit board sections (12, 14, 16, 18, 20, 22) are angled away in such a way that they form the side faces of a closed housing (26).

16. Method for producing a printed circuit board structure capable of being angled according to any of the preceding claims, **characterized in that** the flat printed circuit board (1) is provided at least on its side facing towards the conducting wire (4) with at least one cover layer (10) of insulating material prior to the angling.

17. Method for producing a printed circuit board structure capable of being angled according to any of the preceding claims, **characterized in that** electrical or electronic components are connected to at least some of the connection points (6) prior to or after the angling.

18. Wire-written printed circuit board structure which is capable of being angled and composed of at least two printed circuit board sections (12, 14, 16, 18, 20, 22) which can be arranged such as to be angled relative to one another, which contains etched traces (8) and at least one conducting wire (4) which is at least predominantly embedded in the printed circuit board structure (1), which conducting wire extends between two regions of the printed circuit board structure (1) that are provided as connection points (6) and is connected to said connection points in an electrically conductive manner, wherein the two regions that are provided as connection points (6) are located on different printed circuit board sections (12, 14, 16, 18, 20, 22), and an angling edge (28) is provided which is produced by partially removing printed circuit board material, along which angling edge the thickness of the printed circuit board (1) is reduced in comparison to adjoining regions, wherein an angling groove (30), after removing the printed circuit board material along the angling edge (28) on the wire writing side, is spaced apart from the conducting wire (4) in the opposite direction of the printed circuit board (1) and up to 30% of the printed circuit board thickness is retained over the conducting wire (4) on the wire writing side, so that the printed circuit board sections can be angled relative to one another while maintaining the connection of the regions that are provided as connection points (6) by means of the at least one conducting wire (4) and by bending the at least one conducting wire (4).

## Revendications

1. Procédé de fabrication d'une structure de plaque de circuit imprimé susceptible d'être pliée ou coudée et comprenant un circuit de fils noyés, et constituée d'au moins deux tronçons de plaque de circuit imprimé (12, 14, 16, 18, 20, 22), le procédé comprenant les étapes suivantes :
a) fabrication d'une plaque de circuit imprimé plane (1) comprenant des pistes conductrices (8) obtenues par gravure, et au moins un fil conducteur (4), qui est noyé au moins de manière prépondérante dans la plaque de circuit imprimé (1) et s'étend entre deux zones de la plaque de circuit imprimé (1) faisant office de points de connexion (6), en y étant relié de manière conductrice sur le plan électrique, les deux zones prévues en tant que points de connexion (6) se trouvant sur des tronçons de plaque de circuit imprimé (12, 14, 16, 18, 20, 22) différentes ;
b) préparation d'au moins une ligne de pliage (28) entre les tronçons de plaque de circuit imprimé (12, 14, 16, 18, 20, 22), la ligne de pliage (28) étant réalisée par élimination partielle de matériau de plaque de circuit imprimé, et l'épaisseur de la plaque de circuit imprimé (1) étant réduite, le long de la ligne de pliage (28), par rapport aux zones avoisinantes, une rainure de pliage (30) se trouvant, après élimination du matériau de plaque de circuit imprimé le long de la ligne de pliage (28) sur le côté de la plaque de circuit imprimé (1) opposé à celui où se trouve le circuit de fils, à distance du fil conducteur (4), en conservant jusqu'à 30% de l'épaisseur de la plaque de circuit imprimé au-dessus du fil conducteur (4) sur le côté de pose du circuit de fils, de sorte que les tronçons de plaque de circuit imprimé (12, 14, 16, 18, 20, 22) peuvent être pliés les uns par rapport aux autres en conservant la liaison de connexion établie par ledit au moins un fil conducteur (4) entre les zones prévues en tant que points de connexion (6), et en pliant ledit au moins un fil conducteur (4).

2. Procédé de fabrication d'une structure de plaque de circuit imprimé susceptible d'être pliée, selon la revendication 1, **caractérisé en ce que** l'on munit la plaque de circuit imprimé (1), de points de connexion électriques (6).

3. Procédé de fabrication d'une structure de plaque de circuit imprimé susceptible d'être pliée, selon l'une au moins des revendications 1 ou 2, **caractérisé en ce que** le fil conducteur (4) est appliqué par la pose selon un tracé de circuit, et est de préférence soudé aux zones prévues en tant que points de connexion (6).

4. Procédé de fabrication d'une structure de plaque de circuit imprimé susceptible d'être pliée, selon l'une au moins des revendications précédentes, **caractérisé en ce que** la rigidité et/ou la résistance de la plaque de circuit imprimé (1) est abaissée le long de la ligne de pliage (28), par rapport aux zones avoisinantes.

5. Procédé de fabrication d'une structure de plaque de circuit imprimé susceptible d'être pliée, selon l'une des revendications précédentes, **caractérisé en ce qu'**après élimination partielle de matériau de plaque de circuit imprimé, on réalise le pliage d'au moins un tronçon de plaque de circuit imprimé (12, 14, 16, 18, 20, 22) par rapport à au moins un autre tronçon de plaque de circuit imprimé (12, 14, 16, 18, 20, 22), en conservant la liaison de connexion établie par ledit au moins un fil conducteur (4) entre les zones prévues en tant que points de connexion (6), et en pliant ledit au moins un fil conducteur (4).

6. Procédé de fabrication d'une structure de plaque de circuit imprimé susceptible d'être pliée, selon l'une des revendications précédentes, **caractérisé en ce que** l'on fixe en position au moins ledit un tronçon de plaque de circuit imprimé (12, 14, 16, 18, 20, 22) par rapport à un autre tronçon de plaque de circuit imprimé (12, 14, 16, 18, 20, 22).

7. Procédé de fabrication d'une structure de plaque de circuit imprimé susceptible d'être pliée, selon l'une des revendications précédentes, **caractérisé en ce que** la pose des fils avec les zones prévues en tant que points de connexion (6), est effectuée sur un élément de surface, mince, au moins conducteur par secteurs, de préférence une feuille conductrice, et **en ce que** l'élément de surface plan, mince, au moins conducteur par secteurs, est, après la pose des fils, liée par moulage ou par compression, au moins par secteurs, à un moyen d'isolation et de stabilisation, qui renferme de préférence une couche d'armature de renfort, en vue de fabriquer une plaque de circuit imprimé (1).

8. Procédé de fabrication d'une structure de plaque de circuit imprimé susceptible d'être pliée, selon l'une des revendications précédentes, **caractérisé en ce que** le matériau de plaque de circuit imprimé est plié le long de la ligne de pliage (28), dans un état plastique.

9. Procédé de fabrication d'une structure de plaque de circuit imprimé susceptible d'être pliée, selon l'une des revendications précédentes, **caractérisé en ce que** l'élimination du matériau de plaque de circuit imprimé le long de la ligne pliage (28), est effectuée par enlèvement de matière au laser.

10. Procédé de fabrication d'une structure de plaque de circuit imprimé susceptible d'être pliée, selon l'une des revendications précédentes, **caractérisé en ce que** l'élimination du matériau de plaque de circuit imprimé le long de la ligne pliage (28), est effectuée par enlèvement de matière, mécanique, de préférence par fraisage ou sciage.

11. Procédé de fabrication d'une structure de plaque de circuit imprimé susceptible d'être pliée, selon l'une des revendications précédentes, **caractérisé en ce que** dans la zone de la ligne de pliage (28), la feuille conductrice est retirée avant le fraisage.

12. Procédé de fabrication d'une structure de plaque de circuit imprimé susceptible d'être pliée, selon l'une des revendications précédentes, **caractérisé en ce que** le pliage est effectué en s'éloignant de la zone de fraisage.

13. Procédé de fabrication d'une structure de plaque de circuit imprimé susceptible d'être pliée, selon l'une des revendications précédentes, **caractérisé en ce que** cette élimination du matériau de plaque de circuit imprimé le long de la ligne de pliage (8), est effectuée sous la forme d'une rainure (30) en forme de V, et le pliage se fait en direction du côté fraisé.

14. Procédé de fabrication d'une structure de plaque de circuit imprimé susceptible d'être pliée, selon l'une des revendications précédentes, **caractérisé en ce que** le moyen d'isolation et de stabilisation pour la fabrication d'une plaque de circuit imprimé (1), présente une couche d'armature de renfort, qui est agencée au voisinage du circuit de fils, et qui, lors de l'usinage de la structure de plaque de circuit imprimé et du pliage des tronçons de plaque de circuit imprimé (12, 14, 16, 18, 20, 22), reste au moins partiellement conservée.

15. Procédé de fabrication d'une structure de plaque de circuit imprimé susceptible d'être pliée, selon l'une des revendications précédentes, **caractérisé en ce qu'**à partir de la plaque de circuit imprimé plane (1), on plie au moins six tronçons de plaque de circuit imprimé (12, 14, 16, 18, 20, 22) de manière à ce qu'ils forment les surfaces latérales d'un boitier (26) fermé.

16. Procédé de fabrication d'une structure de plaque de circuit imprimé susceptible d'être pliée, selon l'une des revendications précédentes, **caractérisé en ce que** la plaque de circuit imprimé plane (1) est munie, au moins sur son côté dirigé vers le fil conducteur (4), avant le pliage, d'au moins une couche de recouvrement (10) en matériau isolant.

17. Procédé de fabrication d'une structure de plaque de circuit imprimé susceptible d'être pliée, selon l'une des revendications précédentes, **caractérisé en ce que** l'on raccorde des composants électriques ou électroniques à au moins quelques-uns des points de connexion (6), avant ou après le pliage.

18. Structure de plaque de circuit imprimé susceptible d'être pliée ou coudée et comprenant un circuit de fils noyés, constituée d'au moins deux tronçons de plaque de circuit imprimé (12, 14, 16, 18, 20, 22) et renfermant des pistes conductrices (8) obtenues par gravure, et au moins un fil conducteur (4), qui est noyé au moins de manière prépondérante dans la plaque de circuit imprimé (1) et s'étend entre deux zones de la plaque de circuit imprimé (1) faisant office de points de connexion (6), en y étant reliés de manière conductrice sur le plan électrique, les deux zones prévues en tant que points de connexion (6) se trouvant sur des tronçons de plaque de circuit imprimé (12, 14, 16, 18, 20, 22) différentes, une ligne de pliage (28) réalisée par élimination partielle de matériau de plaque de circuit imprimé et le long de laquelle l'épaisseur de la plaque de circuit imprimé (1) est réduite par rapport aux zones avoisinantes, étant prévue entre les tronçons de plaque de circuit imprimé (12, 14, 16, 18, 20, 22), et une rainure de pliage (30) se trouvant, après élimination du matériau de plaque de circuit imprimé le long de la ligne de pliage (28) sur le côté de la plaque de circuit imprimé (1) opposé à celui où se trouve le circuit de fils, à distance du fil conducteur (4), en conservant jusqu'à 30% de l'épaisseur de la plaque de circuit imprimé au-dessus du fil conducteur (4) sur le côté de pose du circuit de fils, de sorte que les tronçons de plaque de circuit imprimé peuvent être pliés les uns par rapport aux autres en conservant la liaison de connexion établie par ledit au moins un fil conducteur (4) entre les zones prévues en tant que points de connexion (6), et en pliant ledit au moins un fil conducteur (4).
